# EUROPÄISCHE PATENTSCHRIFT

(11) **EP 0 366 072 B1**
(45) Veröffentlichungstag und Bekanntmachung des Hinweises auf die Patenterteilung: **05.01.1994**
(21) Anmeldenummer: 89119730.3
(22) Anmeldetag: 24.10.1989
(51) Int. Cl.: G03F 7/023

(54) **Phlegmatisierte Chinondiazid-Verbindungen**
Quinone diazides
Quinone diazides

(30) Priorität: 27.10.1988 DE 3836586
(43) Veröffentlichungstag der Anmeldung: 02.05.1990
(73) Patentinhaber: CIBA-GEIGY AG, 4002 Basel (CH)
(72) Erfinder: Dresely, Stefan, D-6107 Reinheim (DE); Raulin, Ditmar, D-6141 Einhausen (DE)
(74) Vertreter: Zumstein, Fritz, Dr.

(56) Entgegenhaltungen:
- EP-A- 0 055 814
- EP-A- 0 125 587

## Beschreibung

Die Erfindung betrifft phlegmatisierte Chinondiazid-Verbindungen für die Anwendung als fotoaktive Komponenten in strahlungsempfindlichen Zusammensetzungen wie insbesondere Fotoresists, die als Phlegmatisierungsmittel mikrokristalline Cellulose enthalten.

Als Fotoresists werden üblicherweise fotostrukturierbare organische Polymermaterialien bezeichnet, die in photolithographischen Prozessen und verwandten Techniken eingesetzt werden, beispielsweise bei der Herstellung von Druckplatten, von gedruckten elektrischen Schaltungen und Leiterplatten oder in der Mikroelektronik bei der Herstellung von integrierten Halbleiterbauelementen.

Bei der Herstellung von integrierten mikroelektronischen Halbleiterbauelementen wird das Halbleitersubstratmaterial mit dem Fotoresist beschichtet; durch bildmässiges Belichten der Fotoresistschicht und anschliessendes Entwickeln werden dann positive oder negative Fotoresistreliefstrukturen erhalten.Diese dienen als Maske für die eigentlichen Strukturierungsprozesse am Halbleitersubstrat wie Aetzen, Dotieren, Beschichten mit Metallen, anderen Halbleiter- oder auch Isolatormaterialien. Danach werden die Fotoresistmasken in der Regel wieder entfernt. Durch eine Vielzahl derartiger Prozesszyklen entstehen auf dem Substrat die Schaltungsstrukturen der Mikrochips.

Positiv-Fotoresists üblicher Art enthalten in einem organischen Lösungsmittel im wesentlichen mindestens je ein in wässrigen Alkalien lösliches Harz und eine fotoaktive Chinondiazidverbindung, die die Alkalilöslichkeit des Harzes reduziert. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, sodass nach Entwicklung in wässrigalkalischen Entwicklungsbädern positive Fotoresist-Reliefstrukturen erhalten werden.

Als fotoaktive Chinondiazidverbindungen sind bevorzugt Veresterungsprodukte der 1,2-Naphthochinon-2-diazid-5-sulfonsäure oder 1,2-Naphthochinon-2-diazid-4-sulfonsäure mit niedermolekularen aromatischen Hydroxyverbindungen, insbesondere mit Hydroxybenzophenonen wie 2,3,4-Trihydroxybenzophenon und 2,3,4,4′-Tetrahydroxybenzophenon sowie mit Trihydroxybenzolen wie 1,3,5-Trihydroxybenzol im Gebrauch. Diese Naphthochinondiazidverbindungen verfügen über eine breite Absorption im nahen bis mittleren UV-Wellenlängenbereich zwischen ca. 300 und 450 nm. In diesem Wellenlängenbereich liegen kräftige Emissionslinien der üblicherweise in den Projektionsgeräten eingesetzten Quecksilberlampen, wie etwa die Linien bei 313 nm, 334 nm, 365 nm, 405 nm und 436 nm.

Derartige Chinondiazid-Verbindungen - Verbindungen also, die mindestens eine aus zwei Stickstoffatomen bestehende Diazogruppe im Molekül enthalten - erfüllen im allgemeinen mindestens eines der Kriterien des Sprengstoffgesetzes der Bundesrepublik Deutschland. Obgleich die meisten dieser Stoffe als Sprengstoffe im eigentlichen Sinn weder vorgesehen noch geeignet sind, unterliegen sie als "explosionsgefährliche Stoffe" den Bestimmungen dieses Gesetzes. Herstellung, Isolierung, Lagerung und Transport sowie Weiterverarbeitung dieser Substanzen in reiner Form kann daher nur unter sehr aufwendigen Vorsichtsmassnahmen und in relativ geringen Mengen erfolgen.

In Anbetracht der heute weit verbreiteten technischen Anwendung dieser Substanzen ist es daher wünschenswert, diese Verbindungen in stabilisierter Form zur Verfügung zu stellen, so dass diese nicht mehr explosionsgefährlich sind und gefährdungsfrei, möglichst mengenmässig unbeschränkt und unbehindert durch gesetzliche Auflagen und sicherheitstechnische Massnahmen gehandhabt werden können.

Bei der Anwendung in der Mikroelektronik kommt der Reinheit der Fotoresists und der darin enthaltenen Komponenten entscheidende Bedeutung zu. Wesentliche Kriterien hierbei sind die Partikelfreiheit sowie die Abwesenheit von dotierend wirkenden Metallionen und von Feuchtigkeit. Die Verarbeitungseigenschaften und die Abbildungsqualität des Fotoresist sowie die Chipausbeute hängen sehr wesentlich hiervon ab. Hieraus folgt, dass phlegmatisierte Chinondiazid-Verbindungen nur dann für den Einsatz in Fotoresists für die Mikroelektronik geeignet sind, wenn aus der phlegmatisierten Form die Chinondiazid-Verbindung in entsprechender Reinheit und kontaminationsfrei freigesetzt werden kann. In DE-OS 33 17 883 sind phlegmatisierte Formen explosionsgefährlicher Chinondiazid-Verbindungen beschrieben, bei denen unlösliche pulverige anorganische Adsorbentien wie insbesondere Kieselgur, Kieselgel oder Aluminiumoxid als Phlegmatisierungsmittel fungieren. Man erhält diese phlegmatisierten Formen, in dem man die Chinondiazid-Verbindung aus der Lösung in einem organischen Lösungsmittel durch Fällung in Gegenwart derartiger Adsorbentien abscheidet. In dieser Form sind diese Verbindungen stabil und völlig ungefährlich. Die Chinondiazid-Verbindungen können hieraus wieder regeneriert werden, beispielsweise für die Herstellung von Fotoresists, indem man die phlegmatisierte Form in das organische Lösungsmittel gibt und das anorganische Material, etwa durch Filtration, wieder abtrennt.

Es hat sich jedoch herausgestellt, dass durch derart phlegmatisierte Chinondiazid-Verbindungen in den Fotoresists unerwünschte Mengen an Metallionen, überwiedend Natriumionen aber auch Schwermetallionen, eingeschleppt werden, die sich bei der Strukturierung von Halbleitern als hochgradig störend erweisen können. Diese Einschleppung von Metallionen ist sowohl in qualitativer wie auch in quantitativer Hinsicht, da meist nicht reproduzierbar, nur schwer zu beherrschen.

Es bestand daher die Aufgabe, alternative Phlegmatisierungsmittel für Chinondiazid-Verbindungen zu finden, die eine mindestens gleichermassen wirksame Phlegmatisierung ermöglichen und hinsichtlich Metallionengehalt und -einschleppung bei der Anwendung in Fotoresists für die Halbleiterstrukturierung unbedenklich sind.

Ueberraschend wurde nun gefunden, dass mikrokristalline Cellulose sich in völlig analoger Weise, wie in DE-OS 33 17 883 für anorganische Adsorbentien beschrieben, als Phlegmatisierungsmittel für Chinondiazid-Verbindungen eignet, gleichzeitig aber im Hinblick auf Metallionengehalt und -einschleppung in Fotoresists erheblich günstiger ist. Die durch Fällung aus der Lösung in Gegenwart von mikrokristalliner Cellulose erhältlichen phlegmatisierten Chinondiazid-Verbindungen sind stabil und völlig ungefährlich. Durch einfaches Auflösen und Abfiltrieren des Phlegmatisierungsmittels können sie für den weiteren Einsatz problemlos regeneriert werden.

Gegenstand der Erfindung sind daher phlegmatisierte Chinondiazid-Verbindungen für die Anwendung als fotoaktive Komponenten in strahlungsempfindlichen Zusammensetzungen, die als Phlegmatisierungsmittel mikrokristalline Cellulose enthalten.

Gegenstand der Erfindung ist weiterhin die Verwendung von mikrokristalliner Cellulose als Phlegmatisierungsmittel für Chinondiazid-Verbindungen.

Gegenstand der Erfindung ist darüberhinaus ein Verfahren zur Herstellung von phlegmatisierten Chinondiazid-Verbindungen, bei dem man diese aus der Lösung in Gegenwart von mikrokristalliner Cellulose abscheidet.

Die erfindungsgemäss als Phlegmatisierungsmittel für Chinondiazid-Verbindungen fungierende mikrokristalline Cellulose ist ein gängiges, beliebig verfügbares, für die unterschiedlichsten Zwecke industriell hergestelltes Produkt. Es kommt üblicherweise als feinpulveriges Produkt in den Handel; die Teilchengrösse liegt in der Regel zwischen etwa 0,01 und 0,5 mm, ist aber für den erfindungsgemässen Zweck völlig unkritisch. Mikrokristalline Cellulose ist in Wasser und praktisch allen organischen Lösungsmitteln, insbesondere den in der Fotoresisttechnik üblichen Lösungsmitteln, unlöslich. In den erfindungsgemäss mit mikrokristalliner Cellulose phlegmatisierten Chinondiazid-Verbindungen liegt das Phlegmatisierungsmittel in einem Anteil von 10-90 Gew.%, vorzugsweise 40-60 Gew.% und insbesondere von etwa 50 Gew.% vor.

Erfindungsgemäss können mit dem genannten Material alle für die Herstellung strahlungsempfindlicher Zusammensetzung gebräuchlichen Chinondiazid-Verbindungen in eine phlegmatisierte, also nicht mehr explosionsgefährliche Form überführt werden.

Besonders bevorzugte derartige Verbindungen sind die Veresterungsprodukte der 1,2-Naphthochinon-2-diazid-4-sulfonsäure mit niedermolekularen aromatischen Hydroxyverbindungen, insbesondere mit Hydroxybenzophenonen wie 2,3,4-Trihydroxybenzophenon und 2,3,4,4′-Tetrahydroxybenzophenon sowie mit Trihydroxybenzolen wie 1,3,5-Trihydroxybenzol.

Das erfindungsgemässe Verfahren zur Herstellung phlegmatisierter Formen solcher in reiner Form explosionsgefährlicher Chinondiazid-Verbindungen erfolgt in der Weise, dass man diese aus ihren Lösungen durch Fällung in Gegenwart von mikrokristalliner Cellulose abscheidet, welche man vor der Fällung den Lösungen bzw. dem Fällungsmittel zugesetzt hat. Hierbei stellt man die Chinondiazid-Verbindung zunächst in an sich bekannter Weise her, jedoch ohne diese in reiner, trockener und somit explosionsgefährlicher Form zu isolieren. Vielmehr löst man die noch wasser- bzw. lösungsmittelfeuchten Produkte in einem der gängigen Lösungsmittel, fügt nun das erfindungsgemässe Phlegmatisierungsmittel zu und scheidet durch Fällung mit einem der hierfür üblichen Fällungsmittel die Chinondiazid-Verbindungen in durch mikrokristalline Cellulose phlegmatisierter Form ab. Ebenso kann die Abscheidung der Produkte in phlegmatisierter Form in der Art erfolgen, dass ihre Lösungen zu einer Mischung aus Phlegmatisierungsmittel und Fällungsmittel zugefügt werden. Das jeweilige Produkt kann dann durch Filtration abgetrennt und problemlos getrocknet werden. Dieses Verfahren ist somit sehr einfach durchzuführen und ist in Bezug auf die zugesetzte Menge an Phlegmatisierungsmittel in einem weiten Rahmen unkritisch. Man erreicht in jedem Falle eine wirksame Phlegmatisierung, wenn man die mikrokristalline Cellulose in einem Anteil von 10-90 Gew.%, bezogen auf die Menge in Chinondiazid-Verbindung, zusetzt. Die günstigsten Ergebnisse erzielt man bei einem Anteil von 40-60 Gew.%, insbesondere von etwa 50 Gew.%.

Die nach dem erfindungsgemässen Verfahren in eine phlegmatisierte Form überführten Chinondiazid-Verbindungen zeigen im Gegensatz zu den entsprechenden reinen Verbindungen keinerlei Explosionsgefährlichkeit mehr. Dies wird nach den Vorschriften des Sprengstoffgesetzes mit bestimmten Tests geprüft (s. Ullmann, Enzyklopädie der technischen Chemie, Bd. 21, S. 649-650 und S. 652).

Als explosionsgefährlich werden demnach Stoffe eingestuft, wenn im
a) Fallhammertest bei einer Schlagenergie von 40 Joule (10 kg Fallgewicht, 40 cm Fallhöhe) oder weniger eine Explosion erfolgt oder
b) im Stahlhülsentest bei einem Düsendurchmesser von 2 mm oder mehr Explosion eintritt oder
c) im Reibungstest bei einer Stiftbelastung von 360 N oder darunter Explosion, Entflammung oder Knistern auftritt.

Die erfindungsgemäss phlegmatisierten Chinondiazid-Verbindungen erfüllen keines der genanntenKriterien für die Explosionsgefährlichkeit. Sie können also problemlos und in beliebiger Menge wie gewöhnliche Chemikalien gehandhabt werden.

Die gemäss der vorliegenden Erfindung phlegmatisierten Chinondiazid-Verbindungen eignen sich in hervorragender Weise zur Herstellung strahlungsempfindlicher Zusammensetzungen, wie sie zur Erzeugung von positiven Reliefbildern bei der Herstellung von Druckplatten oder als Fotoresists bei der Halbleiterfertigung Verwendung finden. Ihre problemlose Handhabbarkeit aufgrund des Fehlens jeglicher Explosionsgefahr macht sie angesichts des hohen Bedarfs und Verbrauchs an strahlungsempfindlichen Zusammensetzungen besonders wertvoll für die technische Anwendung.

Die Herstellung strahlungsempfindlicher Zusammensetzungen, die derartige Chinondiazid-Verbindungen enthalten, erfolgt so, dass man die Komponenten in üblicher Weise entsprechend den an sich bekannten Formulierungen in einem organischen Lösungsmittel mischt, wobei man zunächst die mit mikrokristalliner Cellulose phlegmatisierte Chinondiazid-Verbindung in dem Lösungsmittel löst und dann das unlösliche Material vor oder nach der Mischung mit den weiteren Komponenten der strahlungsempfindlichen Zusammensetzung abtrennt. Diese Abtrennung kann durch Filtration erfolgen.

Das Verfahren zur Herstellung strahlungsempfindlicher Zusammensetzung gestaltet sich besonders vorteilhaft, da durch die Anwesenheit der mikrokristallinen Cellulose die ohnehin erforderliche Filtration der fertigen Lösungen erleichtert wird und daher auf einen etwaigen Zusatz von Filtrierhilfsmitteln verzichtet werden kann.

Als besonders überraschend hat sich hierbei herausgestellt, dass die Abfiltration der mikrokristallinen Cellulose leichter und deutlich schneller vonstatten geht als die der anorganischen Adsorbentien gemäss DE-OS 33 17 883. Auch können die Fotoresistlösungen, die mit erfindungsgemäss mit mikrokristalliner Cellulose phlegmatisierten Chinondiazid-Verbindungen hergestellt worden sind, sofort und ohne weiteres der abschliessenden Feinstfiltration durch Membranfilter (Porenweite üblicherweise zwischen 0,1 und 1 µm) unterzogen werden. Im Falle der Phlegmatisierung mit anorganischen Adsorbentien waren demgegenüber weitere Vor- und Zwischenfiltrationen erforderlich.

Die so hergestellten Fotoresists weisen einen erheblich niedrigeren Metallionengehalt auf. So lässt sich beispielsweise gegenüber Fotoresists, die auf mit anorganischen Adsorbentien phlegmatisierten Chinondiazid-Verbindungen basieren, der Gehalt an den besonders unerwünschten Natriumionen um den Faktor 50-100 und der Gehalt an Eisenionen um den Faktor 10 reduzieren.

Als ein weiterer, völlig unerwarteter und überraschender Effekt der Vewendung von erfindungsgemäss mit mikrokristalliner Cellulose phlegmatisierten Chinondiazid-Verbindungen in Positiv-Fotoresists ist deren erheblich verbesserte Lagerstabilität, insbesondere im Hinblick auf das Auftreten von "black spots".

Feststoffpartikel wie allgegenwärtige Staubteilchen oder Partikel, die durch lagerbedingte Veränderungen in der Fotoresistlösung entstehen, führen, insbesondere wenn deren Dimension in der Grössenordnung der abzubildenden Strukturen oder darüber liegen, zu unerwünschten Ausbeuteverlusten an funktionsfähigen Mikrochips durch das Auftreten der sogenannten "black spots". Lagerbedingte Veränderungen, die zu Feststoffpartikelausscheidungen in der Fotoresistlösung fuhren, werden überwiegend durch unkontrollierte Zersetzung im Anteil an fotoempfindlicher Chinondiazid-Verbindung verursacht. Derartige Zersetzungsvorgänge treten vielfach in unterschiedlichem Umfang auf und sind, trotz grösstmöglicher Standardisierung bei der Herstellung sowohl der Ausgangsstoffe als auch der Fotoresists, produktions- und chargenbedingt. Deshalb ist es angezeigt, nach längerer Lagerung die Fotoresistlösung direkt vor der Anwendung erneut einer Feinfiltration zu unterziehen. Braun gefärbte Filter sind ein sicheres Anzeichen für Zersetzung von Chinondiazid-Verbindung und für das Auftreten von die Chipausbeute vermindernden "black spots".

Im Vergleich zu Fotoresists, die mit nicht phlegmatisierten oder mit anorganischen Adsorbentien phlegmatisierten Chinondiazid-Verbindungen hergestellt sind, zeigen die Fotoresists basierend auf mit mikrokristalliner Cellulose phlegmatisierten Chinondiazid-Verbindungen praktisch keinerlei lagerungsbedingtes Auftreten von "black spots". Der Einsatz der erfindungsgemäss phlegmatisierten Chinondiazid-Verbindungen führt somit auch zu qualitativ und anwendungstechnisch erheblich verbesserten Fotoresists.

### Beispiel 1: Herstellung phlegmatisierter Chinondiazid-Verbindungen.

10 g eines Trisesters von 1,2-Naphthochinon-2-diazid-5-sulfonsäure mit 1,3,5-Trihydroxybenzol werden in 40 ml Aceton gelöst. Diese Lösung wird langsam zu einer intensiv gerührten Suspension von 10 g mikrokristalliner Cellulose in 150 ml 1%iger Salzsäure gegeben. Dabei wird die Chinondiazid-Verbindung ausgefällt und durch Filtration in mit Cellulose phlegmatisierter Form isoliert.

Analog werden hergestellt phlegmatisierte Formen von:
Trisester von 1,2-Naphthochinon-2-diazid-4-sulfonsäure mit 1,3,5-Trihydroxybenzol
Veresterungsprodukt von 1,2-Naphthochinon-2-diazid-5-sulfonsäure mit 2,3,4-Trihydroxybenzophenon
Zur Prüfung der Explosionsgefährlichkeit werden die Substanzen gemäss den Vorschriften des Sprengstoffgesetzes mit dem Fallhammertest, dem Stahlhülsentest und dem Reibungstest untersucht. Keine der phlegmatisierten Formen spricht auf diese Tests an, während die reinen Substanzen allein schon im Fallhammertest eine deutlich positive Reaktion zeigen.

### Beispiel 2: Herstellung von Fotoresist-Lösungen

Es werden 2 Positiv-Fotoresist-Formulierungen durch Mischen der Komponenten mit jeweils der Zusammensetzung
30 Gew.% p-Kresol-Novolakharz
10 Gew.% Trisester von 1,2-Naphthochinon-2-diazid-5-sulfonsäure mit 1,3,5-Trihydroxybenzol
60 Gew.% Diethylenglykoldimethylether
hergestellt, wobei für Lösung A die phlegmatisierte Chinon-diazid-Verbindung gemäss Beispiel 1 und für Lösung B die mit Kieselgur (gemäss DE-OS 33 17 883) phlegmatisierte Chinondiazid-Verbindung verwendet wird. Aus den Lösungen werden die Phlegmatisierungsmittel durch Filtration entfernt. Durch erneute Filtration durch ein Membranfilter mit 0,2 µm Porenweite werden die Lösungen in gebrauchsfertige Fotoresistlösungen überführt.

### Beispiel 3: Metallionengehalt

Proben der Fotoresistlösungen A und B aus Beispiel 2 werden nach üblicher Probenvorbereitung mittels Atomemissionsspektroskopie auf den Metallionengehalt untersucht.

### Ergebnis (Werte in µg/g Analysenlösung):

| Metallion | A | B |
|---|---|---|
| Al | 0.05 | 0.70 |
| Ca | < 0.05 | 0.30 |
| Cr | < 0.05 | < 0.05 |
| Cu | < 0.05 | 0.06 |
| Fe | < 0.05 | 0.50 |
| K | < 0.50 | 0.90 |
| Li | < 0.50 | < 0.50 |
| Mg | < 0.05 | 0.13 |
| Na | 0.10 | 6.70 |
| Ni | < 0.05 | < 0.05 |
| Zn | < 0.50 | < 0.50 |

Es zeigt sich, dass Lösung A (erfindungsgemäss) einen erheblich niedrigeren Metallionengehalt aufweist. Der Natriumionengehalt ist drastisch reduziert.

### Beispiel 4: Lagerstabilität

Proben der Fotoresistlösungen A und B werden eine Woche lang bei 50°C gelagert.

Danach werden die Proben erneut durch ein 0,2 µm Filter filtriert.

### Ergebnis:

- Lösung A:: keine Verfärbung des Filters, keine Filtrationsrückstände
- Lösung B:: bräunliche Verfärbung des Filters, braunschwarze, in Aceton unlösliche Filtrationsrückstände.

## Patentansprüche

1. Phlegmatisierte Chinondiazid-Verbindungen für die Anwendung als fotoaktive Komponenten in strahlungsempfindlichen Zusammensetzungen, dadurch gekennzeichnet, dass sie als Phlegmatisierungsmittel mikrokristalline Cellulose enthalten.

2. Phlegmatisierte Chinondiazid-Verbindungen gemäss Anspruch 1, worin die Chinondiazidverbindung einen Ester der 1,2-Naphthochinon-2-diazid-4-sulfonsäure oder der 1,2-Naphthochinon-2-diazid-5-sulfonsäure mit einer niedermolekularen aromatischen Hydroxyverbindung darstellt.

3. Phlegmatisierte Chinondiazid-Verbindungen gemäss Anspruch 2, worin die niedermolekulare aromatische Verbindung ein Hydroxybenzophenon oder ein Trihydroxybenzol bedeutet.

4. Phlegmatisierte Chinondiazid-Verbindungen gemäss Anspruch 1, dadurch gekennzeichnet, dass der Anteil an Phlegmatisierungsmittel 10-90 Gew.%, vorzugsweise 40-60 Gew.% beträgt.

5. Verfahren zur Herstellung von phlegmatisierten Chinondiazid-Verbindungen, dadurch gekennzeichnet, dass man sie aus der Lösung in Gegenwart von mikrokristalliner Cellulose abscheidet.

6. Verwendung von mikrokristalliner Cellulose als Phlegmatisierungsmittel für Chinondiazid-Verbindungen.

## Claims

1. A desensitised quinone diazide compound for use as a photoactive component in radiation-sensitive compositions, which compound contains microcrystalline cellulose as desensitising agent.

2. A desensitised quinone diazide compound according to claim 1, wherein the quinone diazide compound is an ester of 1,2-naphthoquinone-2-diazide-4-sulfonic acid or of 1,2-naphthoquinone-2-diazide-5-sulfonic acid with a low-molecular-weight aromatic hydroxy compound.

3. A desensitised quinone diazide compound according to claim 2, wherein the low-molecular-weight aromatic compound is a hydroxybenzophenone or a trihydroxybenzene.

4. A desensitised quinone diazide compound according to claim 1, wherein the proportion of desensitising agent is from 10 to 90 % by weight, preferably from 40 to 60 % by weight.

5. A process for the preparation of a desensitised quinone diazide compound, which comprises separating it from solution in the presence of microcrystalline cellulose.

6. The use of microcrystalline cellulose as desensitising agent for a quinone diazide compound.

## Revendications

1. Quinone-diazides stabilisés pour servir de constituants photo-actifs dans des compositions sensibles à des rayonnements, composés caractérisés en ce qu'ils contiennent, comme agent de stabilisation, de la cellulose microcristalline.

2. Quinone-diazides stabilisés selon la revendication 1, dans le cas desquels le quinone-diazide est un ester de l'acide 1,2-naphtoquinone-2-diazide-4-sulfonique ou l'acide 1,2-naphtoquinone-2-diazide-5-sulfonique avec un composé hydroxylé aromatique à bas poids moléculaire.

3. Quinone-diazides stabilsés selon la revendication 2, dans le cas desquels le composé aromatique à bas poids moléculalre est une hydroxybenzophénone ou un trihydroxybenzène.

4. Quinone-diazides stabilisés selon la revendication 1, caractérisés en ce que la proportion de l'agent de stabilisation représente 10 à 90 % en poids, avantageusement 40 à 60 % en poids.

5. Procédé pour produire des quinone-diazides stabilisés, procédé caractérisé en ce qu'on les sépare de leurs solutions en opérant en présence de cellulose microcristalline.

6. Utilisation de cellulose microcristalline à titre d'agent de stabilisation pour des quinone-diazides.
